# EUROPÄISCHE PATENTSCHRIFT

(11) **EP 1 637 021 B1**
(45) Veröffentlichungstag und Bekanntmachung des Hinweises auf die Patenterteilung: **13.12.2006**
(21) Anmeldenummer: 04739652.8
(22) Anmeldetag: 07.06.2004
(51) Int. Cl.: H05K 7/20, F24F 5/00

(54) **KÜHLANLAGE FÜR EINEN ODER MEHRERE SCHALTSCHRÄNKE**
COOLING PLANT FOR ONE OR MORE SWITCH CABINETS
INSTALLATION REFRIGERANTE POUR UNE OU PLUSIEURS ARMOIRES DE DISTRIBUTION

(30) Priorität: 07.06.2003 DE 10325929
(43) Veröffentlichungstag der Anmeldung: 22.03.2006
(73) Patentinhaber: Rittal GmbH & Co. KG, 35745 Herborn (DE)
(72) Erfinder: NICOLAI, Michael, 35466 Rabenau (DE); DÖRRICH, Martin, 35764 Sinn (DE)
(74) Vertreter: Fleck, Hermann-Joseph
(86) Internationale Anmeldenummer: PCT/EP2004/006114
(87) Internationale Veröffentlichungsnummer: WO 2004/110124

(56) Entgegenhaltungen:
- EP-A- 0 741 269
- DE-A- 10 112 389
- PATENT ABSTRACTS OF JAPAN vol. 017, no. 183 (E-1348), 9. April 1993 (1993-04-09) -& JP 04 335557 A (FUJITSU LTD), 24. November 1992 (1992-11-24)
- PATENT ABSTRACTS OF JAPAN vol. 2002, no. 10, 10. Oktober 2002 (2002-10-10) -& JP 2002 168479 A (TAKASAGO THERMAL ENG CO LTD), 14. Juni 2002 (2002-06-14)
- PATENT ABSTRACTS OF JAPAN vol. 2002, no. 08, 5. August 2002 (2002-08-05) -& JP 2002 122348 A (FUJITSU LTD), 26. April 2002 (2002-04-26)

## Beschreibung

Die Erfindung betrifft eine Kühlanlage zur Kühlung von einem oder mehreren Schaltschränken mit im Innenraum derselben übereinander angeordneten, wärmeerzeugenden Einbauten, denen individuelle Kühlkörper zugeordnet oder selbst als Kühlkörper ausgebildet sind, wobei diese Kühlkörper in einen Kühlmittelkreislauf einbezogen sind, der von der Wasser-Ausgangsseite eines Luft-/Wasser-Wärmetauschers über eine Vorlaufleitung und einer Rücklaufleitung gespeist sind.

Eine derartige Kühlanlage zur Kühlung eines derartig ausgerüsteten Schaltschrankes ist aus der DE 101 12 389 A1 und JP 04335557 bekannt. Bei dieser Kühlanlage sind die Kühlkörper als plattenförmige Aufnahme-Wärmetauscher ausgebildet und in den Zwischenschlitzen zwischen den Einbauten angeordnet. Der große Luft-/Wasser-Wärmetauscher ist außerhalb des Schaltschrankes angeordnet und muss mit dem als Abgabe-Wärmetauscher mit den Komponenten der Kühlanlage im Schaltschrank-Innenraum verbunden werden. Der Abgabe-Wärmetauscher wird nur von der Umgebungsluft des Schaltschrankes gekühlt und hat daher einen begrenzten Wärme-tauscher-Wirkungsgrad. Zudem ist der Aufbau des Schaltschrankes mit der Kühlanlage kompliziert und aufwändig.

Aus der DE 696 17 089 T2 ist eine Anordnung zur Kühlung eines Schaltschrankes mit im Innenraum übereinander angeordneten wärmeerzeugenden Einbauten bekannt. Die Einbauten werden von einem Kühlluftstrom gekühlt, der von einer zentralen Kühlluftanlage erzeugt und einem Hohlraum zwischen dem Doppelboden des Schaltschrank-Aufstellungsraumes zugeführt wird. Dabei wird der Kühlluftstrom über den Boden des Schaltschrankes eingeleitet und strömt über die verbleibenden Luftkanäle zwischen den Einbauten und dem Schaltschrankgehäuse nach oben und kann über Luftauslässe in der Schaltschrankoberseite in den Schaltschrank-Aufstellungsraum austreten. Obwohl die dem Schaltschrank-Innenraum zugeführte Kühlluft kälter gewählt werden kann wie eine Raumluft, lässt die Wirkung der Kühlanlage im Wirkungsgrad zu wünschen übrig. Dies um so mehr als heute kompakte Einbauten mit erheblich höherer Wärmeerzeugung im Schaltschrank-Innenraum in größerer Packungsdichte untergebracht werden.

Es ist Aufgabe der Erfindung, eine Kühlanlage der eingangs erwähnten Art zu schaffen, bei der der Aufbau des Schaltschrankes einfach bleibt und einer oder mehrere davon von Luft-/Waser-Wärmetauschern gekühlt werden können, die eine zentrale Klimatisierungseinrichtung optimal ausnützen.

Diese Aufgabe wird nach der Erfindung dadurch gelöst, dass ein Groß-Wärmetauscher oder mehrere parallel betriebene Klein-Wärmetauscher in einem Wärmetauscher-Schrank untergebracht ist (sind), wobei der Innenraum des Wärmetauscher-Schrankes über eine Lufteintrittsöffnung im Schrankboden und eine Luftaustrittsöffnung eines Doppelbodens mit einer den Doppelboden mit Kaltluft speisenden zentralen Klimatisierungseinrichtung gekoppelt ist, dass die dem Wärmetauscher-Schrank zugeführte Kaltluft über den Groß-Wärmetauscher oder die Klein-Wärmetauscher geführt ist und das darin fließende Kühlmittel kühlen und dass der Wasservorlauf und der Wasserrücklauf des Groß-Wärmetauschers oder der Klein-Wärmetauscher mit der Vorlaufleitung und der Rücklaufleitung der zu kühlenden Schaltschränke verbunden sind.

Die Schaltschränke können kompakt und vollständig mit Einbauten belegt einfach mit dem Wärmetauscher-Schrank verbunden werden und darüber mit Kühlmittel für die Kühlkörper versorgt werden. Der Wärmetauscher-Schrank mit dem Groß-Wärmetauscher oder den parallel geschalteten Klein-Wärmetauschern erhält die Kaltluft aus einem Doppelboden, der von einer zentralen Klimatisierungseinrichtung mit Kaltluft gespeist wird. Dabei bleibt die Aufstellung und Kopplung des Wärmetauscher-Schrankes auf und mit dem Doppelboden einfach. Zudem kann der Wärmetauscher-Schrank in seiner Leistung optimal an die zu kühlenden Schaltschränke angepasst werden. Die Anzahl der Kühlanlage umfasst getrennte Baueinheiten, die ohne großen Montageaufwand in einem Aufstellraum aufstellbar und miteinander verbindbar sind.

Ein Wärmetauscher-Schrank mit einem Groß-Wärmetauscher mit großem Austauschwirkungsgrad ist nach einer Ausgestaltung so ausgeführt, dass der Groß-Wärmetauscher im Innenraum des Wärmetauscher-Schrankes geneigt eingebaut ist und sich über die gesamte Höhe des Innenraumes erstreckt, während ein Wärmetauscher-Schrank mit mehreren Klein-Wärmetauschern so gestaltet ist, dass die Klein-Wärmetauscher horizontal ausgerichtet übereinander angeordnet sind und den Innenraum des Wärmetauscher-Schrankes bis auf kleine Zwischenräume ausfüllen.

Für die Strömung des Kühlmittels ist im einen Fall vorgesehen, dass in die Vorlaufleitung des Groß-Wärmetauschers eine Pumpe und ein Ausdehnungsgefäß eingeschaltet sind, während im anderen Fall die Strömung dadurch erreicht wird, dass in die Vorlaufzuleitungen der Klein-Wärmtauscher individuelle Pumpen eingeschaltet sind und dass in die Vorlaufzuleitung des obersten Klein-Wärmetauschers zusätzlich ein Ausdehnungsgefäß eingeschaltet ist.

Die Zirkulation der zugeführten Kaltluft wird im Wärmetauscher-Schrank dadurch verbessert, dass auf dem Wärmetauscher-Schrank ein Lüfter angeordnet ist, dessen Luftansaugöffnung über eine Luftaustrittsöffnung des Wärmetauscher-Schrankes mit dem Innenraum desselben in Verbindung steht. Dabei kann für die Abführung der zwischenzeitlich erwärmten Luft vorgesehen sein, dass der Lüfter die aus dem Innenraum des Wärmetauscher-Schrankes abgesaugte Luft axial oder radial in den den Wärmetauscher-Schrank umgebende Raumluft abführt.

Die Parallelschaltung der Klein-Wärmetauscher im Wärmetauscher-Schrank erfolgt raumsparend einfach dadurch, dass die Klein-Wärmetauscher über eine vertikale Vorlaufleitung und eine vertikale Rücklaufleitung parallel geschaltet sind, die sich über die Höhe des Innenraumes des Wärmetauscher-Schrankes erstreckt. Dabei kann der Kühlmittelkreislauf dadurch verbessert werden, dass die Vorlaufleitung und die Rücklaufleitung im oberen Bereich des Innenraumes über eine Verbindungsleitung mit einer Entlüftungsvorrichtung miteinander verbunden sind.

Die Verlegung der Vorlaufleitung und der Rücklaufleitung im Wärmetauscher-Schrank wird dann vereinfacht, wenn bei einem Wärmetauscher-Schrank mit Rahmengestell und Verkleidungselementen die Vorlaufleitung und die Rücklaufleitung in einer Aufnahme oder einem Hohlraum von vertikalen Rahmenschenkeln des Rahmengestelles geführt sind.

Der Wirkungsgrad der Kühlung kann nach einer Weiterbildung dadurch noch erhöht werden, dass die mit den Einbauten versehenen Schaltschränke mit einer Bodenöffnung mit dem Doppelboden gekoppelt und mit Kaltluft zur zusätzlichen Kühlung der Einbauten versorgt sind.

Die Erfindung wird anhand von Ausführungsbeispielen näher erläutert. Es zeigen:
- Fig. 1: schematisch einen Wärmetauscher-Schrank mit einem Groß-Wärmetauscher und
- Fig. 2: schematisch einen Wärmetauscher-Schrank mit mehreren Klein-Wärmetauschern.

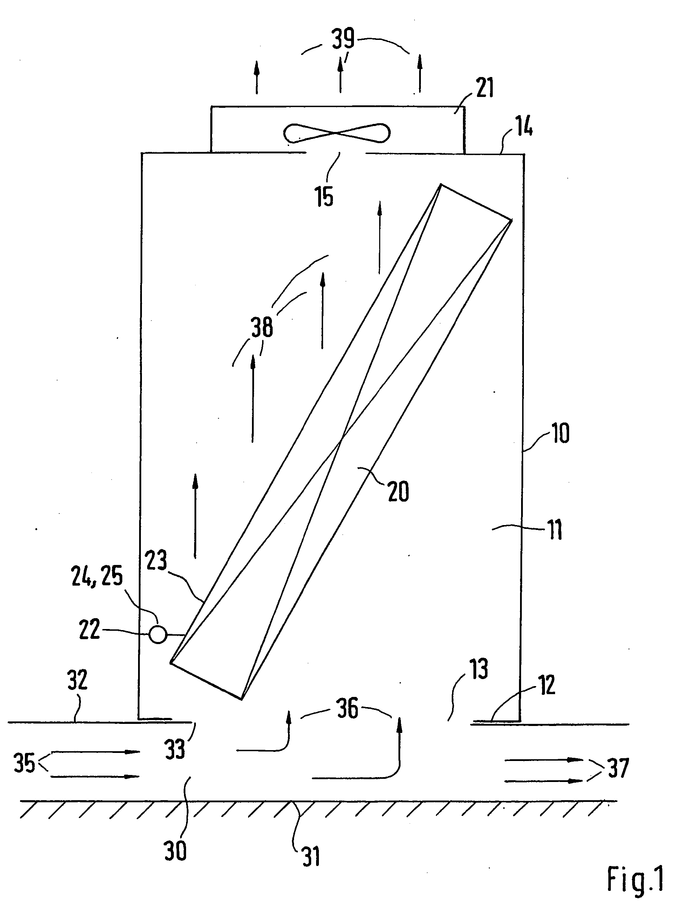

Für den kompakten Ausbau eines Schaltschrankes mit Servern als Einbauten gibt es verschiedene Varianten. Gemeinsam ist dabei der Anschluss des Kühlmittelkreislaufes über eine Vorlaufleitung und eine Rücklaufleitung, die aus dem Schaltschrank herausgeführt und mit den entsprechenden Anschlüssen eines Luft-/Wasser-Wärmetauschers verbunden sind. Um einen anpassungsfähigen Ausbau der Kühlanlage mit einem oder mehreren Schaltschränken zu bekommen, sieht die Erfindung einen Wärmetauscher-Schrank 10 vor, der einen leistungsfähigen Groß-Wärmetauscher 20 aufnimmt, wie Fig. 1 an einem Ausführungsbeispiel zeigt. Dieser Groß-Wärmetauscher 20 hat auf der Wasser-Ausgangsseite einen Vorlaufanschluss 22 und einen Rücklaufanschluss 23, der aus dem Wärmetauscher-Schrank 10 herausgeführt und mit der Vorlaufleitung und Rücklaufleitung eines oder mehrerer Schaltschränke verbunden werden kann. Vorlauf- und Rücklaufleitung der Kühlkörper in den Schaltschränken schließen den Kühlmittelkreislauf, der in der Aufbaustellung mit dem Kühlmittel, z.B. Wasser, gefüllt wird. Die Kühlkörper in den Schaltschränken sind parallel geschaltet.

In den Vorlaufanschluss 22 des Groß-Wärmetauschers 20 sind eine Pumpe 24 und ein Ausdehnungsgefäß 25 eingeschaltet, um die Strömung und den Druck im Kühlmittelkreislauf aufrecht zu erhalten. Der Schrankboden 12 weist eine Lufteintrittsöffnung 13 auf, die über eine freigelegte Luftaustrittsöffnung 33 im oberen Bodenteil 32 des Doppelbodens 30 eine Kopplung zwischen dem Innenraum 11 des Wärmetauscher-Schrankes 10 über den Doppelboden 30 mit einer zentralen, nicht dargestellten Klimatisierungseinrichtung herstellt. Der untere Bodenteil 32 schließt den Doppelboden 30 ab. Die zentrale Klimatisierungseinrichtung speist Kaltluft 35 in den Doppelboden 30, von der ein Teil 36 dem Innenraum 11 des Wärmetauscher-Schrankes 10 zugeführt wird. Wie die Pfeile 37 zeigen, wird die restliche Kaltluft 37 im Doppelboden 30 weitergeleitet. Der Teil 36 durchströmt den Groß-Wärmetauscher 20, der viele Luftkanäle bildet und mit einer großen Kontaktfläche mit der durchströmenden Luft 36 in Kontakt kommt und mit dem durch den Groß-Wärmetauscher 20 fließenden Kühlmittel in Wärmeaustausch tritt. Dabei wird die Luftströmung etwas aufgewärmt und wird als erwärmte Luft 38 von einem auf dem Dach 14 des Wärmetauscher-Schrankes 10 angeordneten Lüfter 21 axial über die Luftaustrittsöffnung 15 angesaugt und z.B. wieder axial in die Umgebungsluft des Wärmetauscher-Schrankes 10 abgeführt, wie die Pfeile 39 andeuten. Der Groß-Wärmetauscher 20 kann in Verbindung mit der Kaltluftversorgung über den Doppelboden und die Leistungsfähigkeit der zentralen Klimatisierungseinrichtung mehrere Schaltschränke mit großer Wärmeerzeugung kühlen. Dabei können die über den Vorlaufanschluss 22 und den Rücklaufanschluss 23 mit Kühlmittel versorgten Schaltschränke über eine Lufteintrittsöffnung im Schrankboden auch mit dem Doppelboden 30 gekoppelt sein und daraus Kaltluft für den Innenraum zur zusätzlichen Kühlung der Einbauten erhalten.

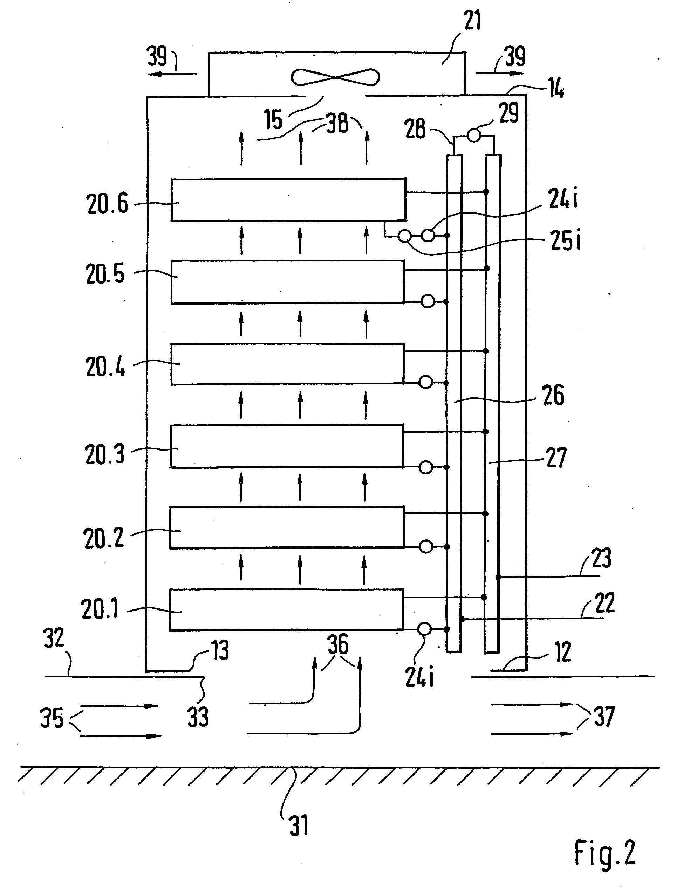

Wie das Ausführungsbeispiel nach Fig. 2 zeigt, kann der Wärmetauscher-Schrank 10 bei gleicher Kopplung mit dem Doppelboden 30 anstelle eines geneigt eingebauten Groß-Wärmetauschers 20 mehrere horizontal ausgerichtete Klein-Wärmetauscher 20.1, 20.2, 20.3, 20.4, 20.5 und 20.6 aufnehmen, die dicht gestapelt sind. In einem vertikalen Kanal sind eine Vorlaufleitung 26 und eine Rücklaufleitung 27 geführt, die als Vorlaufanschluss 22 und als Rücklaufanschluss 23 wieder aus dem Wärmetauscher-Schrank 10 herausgeführt sind und zur Verbindung mit den Schaltschränken benutzt werden.

Die Klein-Wärmetauscher 20.1 bis 20.6 sind mit ihren Rücklaufzuleitungen direkt mit der Rücklaufleitung 27 verbunden, während die Vorlaufzuleitungen der Klein-Wärmetauscher 20.1 bis 20.5 über Pumpen 24i mit der Vorlaufleitung 26 in Verbindung stehen. Bei dem obersten Klein-Wärmetauscher 20.6 ist in die Vorlaufleitung neben einer Pumpe 24i auch noch ein Ausdehnungsgefäß 25.1 eingeschaltet. Die oberen Enden der Vorlaufleitung 26 und der Rücklaufleitung 27 sind über eine Verbindungsleitung 28 mit einer Entlüftungsvorrichtung 29 miteinander verbunden, damit der Kühlmittelkreislauf 20 entlüftet werden kann.

Wie an dem auf dem Dach 14 des Wärmetauscher-Schrankes 10 aufgesetzten Lüfter 21 gezeigt ist, kann dieser die abgesaugte, erwärmte Luft 38 auch radial der Umgebungsluft des Wärmetauscher-Schrankes 10 zugeführt werden.

## Patentansprüche

1. Kühlanlage zur Kühlung von einem oder mehreren Schaltschränken mit im Innenraum derselben übereinander angeordneten, wärmeerzeugenden Einbauten, denen individuelle Kühlkörper zugeordnet oder selbst als Kühlkörper ausgebildet sind, wobei dese Kühlkörper in einen Kühlmittelkreislauf einbezogen sind, der von der Wasser-Ausgangsseite eines in einem Wärmetauscher-schrank (10) untergebrachten Luft-/Wasser-Wärmetauschers über eine Vorlaufleitung und einer Rücklaufleitung gespeist sind, wobei der Innenraum (11) des Wärmetauscher-Schrankes (10) über eine Lufteintrittsöffnung (13) im Schrankboden (12) und eine Luftaustrittsöffnung (13) im Schrankboden (12) und eine Luftaustrittsöffnung (33) eines Doppelbodens (30) mit einer den Doppelboden (30) mit Kaltluft (35) speisenden zentralen Klimatisierungseinrichtung gekoppelt ist,
**dadurch gekennzeichnet,**
**dass** mehrere parallel betriebene Klein-Wärmetauscher (20.1 bis 20.6) in dem Wärmetauscher-Schrank (10) untergebracht sind,
**dass** die dem Wärmetauscher-Schrank (10) zugeführte Kaltluft (36) über die Klein-Wärmetauscher (20.1, 20.6) geführt ist und das darin fließende Kühlmittel kühlen,
**dass** der Wasservorlauf (22) und der Wasserrücklauf (23) der Klein-Wärmetauscher (20.1 bis 20.6) mit der Vorlaufleitung und der Rücklaufleitung der zu kühlenden Schaltschränke verbunden sind,
**dass** in die Vorlaufzuleitungen der Klein-Wärmetauscher (20.1 bis 20.6) individuelle Pumpen (24i) eingeschaltet sind und
**dass** in die Vorlaufzuleitungen des obersten Klein-Wärmetauschers (20.6) zusätzlich ein Ausdehnungsgefäß (25i) eingeschaltet ist.

2. Kühlanlage nach Anspruch 1,
**dadurch gekennzeichnet,**
**dass** die Klein-Wärmetauscher (20.1 bis 20.6) horizontal ausgerichtet übereinander angeordnet sind und den Innenraum (11) des Wärmetauscher-Schrankes (10) bis auf kleine Zwischenräume ausfüllen.

3. Kühlanlage nach Anspruch 1 oder 2,
**dadurch gekennzeichnet,**
**dass** auf dem Wärmetauscher-Schrank (10) ein Lüfter (21) angeordnet ist, dessen Luftansaugöffnungen über eine Luftaustrittsöffnung (15) des Wärmetauscher-Schrankes (10) mit dem Innenraum (11) desselben in Verbindung steht.

4. Kühlanlage nach Anspruch 3,
**dadurch gekennzeichnet,**
**dass** der Lüfter (21) die aus dem Innenraum (11) des Wärmetauscher-Schrankes (10) abgesaugte Luft (38) axial oder radial in den den Wärmetauscher-Schrank (10) umgebende Raumluft abführt.

5. Kühlanlage nach einem der Ansprüche 1 bis 4,
**dadurch gekennzeichnet,**
**dass** die Klein-Wärmetauscher (20.1 bis 20.6) über eine vertikale Vorlaufleitung (26) und eine vertikale Rücklaufleitung (27) parallel geschaltet sind, die sich über die Höhe des Innenraumes (11) des Wärmetauscher-Schrankes (10) erstreckt.

6. Kühlanlage nach Anspruch 5,
**dadurch gekennzeichnet,**
**dass** die Vorlaufleitung (26) und die Rücklaufleitung (27) im oberen Bereich des Innenraumes (11) über eine Verbindungsleitung (28) mit einer Entlüftungsvorrichtung (29) miteinander verbunden sind.

7. Kühlanlage nach Anspruch 5 oder 6,
**dadurch gekennzeichnet,**
**dass** bei einem Wärmetauscher-Schrank (10) mit Rahmengestell und Verkleidungselementen die Vorlaufleitung (26) und die Rücklaufleitung (27) in einer Aufnahme oder einen Hohlraum von vertikalen Rahmenschenkeln des Rahmengestelles geführt sind.

8. Kühlanlage nach einem der Ansprüche 1 bis 7,
**dadurch gekennzeichnet,**
**dass** die mit den Einbauten versehenen Schaltschränke mit einer Bodenöffnung mit dem Doppelboden (30) gekoppelt und mit Kaltluft zur zusätzlichen Kühlung der Einbauten versorgt sind.

## Claims

1. Cooling system for cooling one or more switchgear cabinets having heat-generating internal components which are arranged one above the other in the interior of the said switchgear cabinet or cabinets and have associated individual heat sinks or themselves are in the form of heat sinks, with these heat sinks being included in a coolant circuit which is fed by the water-discharge end of an air/water heat exchanger, which is accommodated in a heat-exchanger cabinet (10), via a feed line and a return line, with the interior (11) of the heat-exchanger cabinet (10) being coupled to a central air-conditioning device which feeds a false floor (30) with cold air (35) via an air-inlet opening (13) in the cabinet floor (12) and an air-outlet opening (13) in the cabinet floor (12) and an air-outlet opening (33) in the false floor (30),
**characterized**
**in that** a plurality of small heat exchangers (20.1 to 20.6) which are operated in parallel are accommodated in the heat-exchanger cabinet (10),
**in that** the cold air (36) which is supplied to the heat-exchanger cabinet (10) is passed across the small heat exchangers (20.1, 20.6) and cools the coolant flowing in the said small heat exchangers,
**in that** the water feed (22) and the water return (23) of the small heat exchangers (20.1 to 20.6) are connected to the feed line and the return line of the switchgear cabinets to be cooled,
**in that** individual pumps (24i) are connected in the feed lines of the small heat exchangers (20.1 to 20.6), and
**in that** an expansion vessel (25i) is additionally connected in the feed lines of the topmost small heat exchanger (20.6).

2. Cooling system according to Claim 1,
**characterized**
**in that** the small heat exchangers (20.1 to 20.6) are arranged one above the other in a horizontally oriented manner and fill the interior (11) of the heat-exchanger cabinet (10), apart from small intermediate spaces.

3. Cooling system according to Claim 1 or 2,
**characterized**
**in that** a fan (21) is arranged on the heat-exchanger cabinet (10), the air-intake openings in the said fan being connected to the interior (11) of the heat-exchanger cabinet (10) via an air-outlet opening (15) in the said heat-exchanger cabinet (10).

4. Cooling system according to Claim 3,
**characterized**
**in that** the fan (21) discharges the air (38) which is taken from the interior (11) of the heat-exchanger cabinet (10) into the atmospheric air, which surrounds the heat-exchanger cabinet (10), in an axial or radial manner.

5. Cooling system according to one of Claims 1 to 4,
**characterized**
**in that** the small heat exchangers (20.1 to 20.6) are connected in parallel via a vertical feed line (26) and a vertical return line (27) which extends over the height of the interior (11) of the heat-exchanger cabinet (10).

6. Cooling system according to Claim 5,
**characterized**
**in that** the feed line (26) and the return line (27) are connected to one another in the upper region of the interior (11) via a connecting line (28) having a ventilation apparatus (29).

7. Cooling system according to Claim 5 or 6,
**characterized**
**in that**, in a heat-exchanger cabinet (10) with a framework and lining elements, the feed line (26) and the return line (27) are guided in a holder or a hollow space by vertical frame legs of the framework.

8. Cooling system according to one of Claims 1 to 7,
**characterized**
**in that** the switchgear cabinets which are provided with the internal components are coupled to the false floor (30) by a floor opening and are supplied with cold air in order to provide additional cooling for the internal components.

## Revendications

1. Équipement de refroidissement pour refroidir une ou plusieurs armoires électriques comprenant des objets installés produisant de la chaleur disposés les uns au-dessus des autres dans l'espace intérieur de celle-ci, auxquels sont associés des éléments refroidisseurs individuels ou qui sont eux-mêmes réalisés sous la forme d'éléments refroidisseurs, ces éléments refroidisseurs étant intégrés dans un circuit de fluide de refroidissement, lequel est alimenté depuis le côté sortie d'eau d'un échangeur de chaleur air/eau logé dans une armoire d'échangeur de chaleur (10) par le biais d'une conduite d'arrivée et d'une conduite de retour, l'espace intérieur (11) de l'armoire d'échangeur de chaleur (10) étant connectée par le biais d'une ouverture d'entrée d'air (13) dans le fond de l'armoire (12) et d'une ouverture de sortie d'air (13) dans le fond de l'armoire (12) et d'une ouverture de sortie d'air (33) d'un double fond (30) avec un dispositif de climatisation central alimentant le double fond (30) en air froid (35), **caractérisé en que** plusieurs petits échangeurs de chaleur (20.1 à 20.6) fonctionnant en parallèle sont logés dans l'armoire d'échangeur de chaleur (10), que l'air froid (36) acheminé à l'armoire d'échangeur de chaleur (10) est acheminé sur les petits échangeurs de chaleur (20.1 à 20.6) et refroidit le fluide de refroidissement qui circule à l'intérieur de ceux-ci, que l'arrivée d'eau (22) et le retour d'eau (23) des petits échangeurs de chaleur (20.1 à 20.6) sont reliés avec la conduite d'arrivée et la conduite de retour des armoires électriques à refroidir, que des pompes (24i) individuelles sont mises en circuit dans les conduites d'arrivée des petits échangeurs de chaleur (20.1 à 20.6) et qu'un vase d'expansion (25i) est en plus mis en circuit dans les conduites d'arrivée du petit échangeur de chaleur le plus haut (20.6).

2. Équipement de refroidissement selon la revendication 1, **caractérisé en ce que** les petits échangeurs de chaleur (20.1 à 20.6) sont disposés les uns au-dessus des autres en étant alignés dans le sens horizontal et remplissent l'espace intérieur (11) de l'armoire d'échangeur de chaleur (10) à l'exception de petits espaces intermédiaires.

3. Équipement de refroidissement selon la revendication 1 ou 2, **caractérisé en ce que** sur l'armoire d'échangeur de chaleur (10) est disposé un ventilateur (21) dont les ouvertures d'aspiration d'air sont en liaison avec l'espace intérieur (11) de l'armoire d'échangeur de chaleur (10) par le biais d'une ouverture de sortie d'air (15) de celle-ci.

4. Équipement de refroidissement selon la revendication 3, **caractérisé en ce que** le ventilateur (21) évacue l'air (38) aspiré hors de l'espace intérieur (11) de l'armoire d'échangeur de chaleur (10) dans le sens axial ou radial dans l'atmosphère entourant l'armoire d'échangeur de chaleur (10).

5. Équipement de refroidissement selon l'une des revendications 1 à 4, **caractérisé en ce que** les petits échangeurs de chaleur (20.1 à 20.6) sont branchés en parallèle par le biais d'une conduite d'arrivée verticale (26) et d'une conduite de retour verticale (27) qui s'étendent sur la hauteur de l'espace intérieur (11) de l'armoire d'échangeur de chaleur (10).

6. Équipement de refroidissement selon la revendication 5, **caractérisé en ce que** la conduite d'arrivée (26) et la conduite de retour (27) sont reliées ensemble dans la zone supérieure de l'espace intérieur (11) par le biais d'une conduite de liaison (28) munie d'un dispositif de purge (29).

7. Équipement de refroidissement selon la revendication 5 ou 6, **caractérisé en ce que** dans le cas d'une armoire d'échangeur de chaleur (10) avec baie et éléments d'habillage, la conduite d'arrivée (26) et la conduite de retour (27) passent dans un logement ou dans un espace creux des branches de cadre verticales de la baie.

8. Équipement de refroidissement selon l'une des revendications 1 à 7, **caractérisé en ce que** l'armoire électrique muni des objets installés est connectée avec le double fond (30) avec une ouverture du fond et elle est alimentée en air froid pour le refroidissement supplémentaire des objets installés.
